# FASCICULE DE BREVET EUROPEEN

(11) **EP 0 765 014 B1**
(45) Date de publication et mention de la délivrance du brevet: **28.07.1999**
(21) Numéro de dépôt: 96401992.1
(22) Date de dépôt: 19.09.1996
(51) Int. Cl.: H01S 3/085, H01S 3/19, H01L 33/00

(54) **Composant d'émission laser à cavité verticale à émission par la surface à une longeur d'onde comprise entre 1,3 et 1,5 micromètre et procédé pour sa réalisation**
Oberflächenemittierender Laser mit vertikalem Resonator mit einer Wellenlänge zwischen 1,3 und 1,5 Mikrometer sowie dessen Herstellung
Surface emitting vertical cavity laser with a wavelength between 1,3 and 1,5 micrometer and its realisation

(30) Priorité: 22.09.1995 FR 9511158
(43) Date de publication de la demande: 26.03.1997
(73) Titulaire: FRANCE TELECOM, 75015 Paris (FR)
(72) Inventeur: Oudar, Jean-Louis, 92290 Chatenay-Malabry (FR)
(74) Mandataire: Le Forestier, Eric

(56) Documents cités:
- APPLIED PHYSICS LETTERS, vol. 65, no. 1, 4 Juillet 1994, WOODBURY, US, pages 97-99, XP000458753 D.L.HUFFAKER ET AL.: "Native-oxide defined ring contact for low threshold vertical-cavity lasers"
- ELECTRONICS LETTERS, vol. 31, no. 11, 25 Mai 1995, STEVENAGE, GB, pages 886-888, XP000519105 G.M.YANG ET AL.: "Ultralow threshold current vertical-cavity surface-emitting lasers obtained with selective oxidation"
- APPLIED PHYSICS LETTERS, vol. 64, no. 12, 21 Mars 1994, WOODBURY, US, pages 1463-1465, XP000434323 DUDLEY J J ET AL: "Low threshold wafer fused long wavelength vertical cavity lasers"
- ELECTRONICS LETTERS, vol. 30, no. 9, 28 Avril 1994, STEVENAGE, GB, pages 704-706, XP000444106 D.I.BABIC ET AL.: "Optically pumped all-epitaxial wafer-fused 1.52um vertical-cavity lasers"
- JOURNAL OF LIGHTWAVE TECHNOLOGY, vol. 4, no. 7, Juillet 1986, NEW YORK, US, pages 846-850, XP002004408 S.UCHIYAMA ET AL.: "GaInAsP/InP surface-emitting lasers with current confining structure"

## Description

La présente invention est relative à un composant d'émission laser à cavité verticale émettant par la surface à une longueur d'onde comprise entre 1,3 et 1,55 µm.

Elle propose également un procédé pour la réalisation de ce composant.

Le composant selon l'invention trouve notamment avantageusement application dans le domaine des télécommunications par fibres optiques ou encore pour la réalisation d'interconnexions optiques à hautes performances permettant le transfert d'informations entre différents éléments de systèmes informatiques.

Classiquement, un composant d'émission laser à cavité verticale est constitué par l'empilement d'un miroir inférieur, d'une cavité comportant la ou les couches actives constituant un milieu amplificateur pour le rayonnement laser, et d'un miroir supérieur.

Les miroirs inférieur et supérieur sont généralement constitués d'un empilement de couches dites quart d'onde, soit en des matériaux semi-conducteurs dopés, soit en des matériaux diélectriques isolants. Ces empilements de couches quart d'onde réalisent des réflecteurs de Bragg centrés sur la longueur d'onde d'utilisation du composant.

La cavité comporte, éventuellement sous la forme de puits quantiques, une ou plusieurs couches de matériaux semi-conducteurs dont la longueur d'onde de bord d'absorption (correspondant à l'énergie de bande interdite) est voisine de celle du rayonnement laser.

La plupart des lasers à cavité verticale réalisés jusqu'à présent et fonctionnant en régime continu à température ambiante ont été réalisés avec un milieu actif en AlGaAs ou en InGaAs épitaxié sur GaAs, et émettent à des longueurs d'onde inférieures à 1 µm.

Des lasers à cavité verticale émettant par la surface à des longueurs d'onde comprises entre 1,3-1,55 µm ont déjà été proposés. Leurs couches actives sont des couches en alliage InGaAsP ou InGaAsAl épitaxiées sur un substrat d'InP.

Toutefois, à ce jour, aucune des structures qui ont été proposées avec ce type de couches actives ne fonctionnent de façon satisfaisante en continu à température ambiante.

Notamment, il a été décrit dans :
[1] T. Baba et al., Electron. Lett. 29, 913 (1993),
   un composant à cavité verticale dont les miroirs sont des miroirs diélectriques complètement isolants. La structure décrite dans cet article présente l'inconvénient d'une assez forte dissipation d'énergie due au passage du courant d'injection dans des couches semi-conductrices très minces et d'une forte élévation de température due à la mauvaise conductivité thermique des miroirs diélectriques. De ce fait, un fonctionnement en continu n'a pu être obtenu que jusqu'à une température de 14°C.
   Il a également été proposé, notamment dans :
[2] K. Streubel et al., Mater. Science and Engineer. B28, 289 (1994)
   d'utiliser des miroirs en InGaAsP/InP. Du fait de la trop faible différence d'indice de réfraction entre les deux couches constituant le réflecteur de Bragg, la réflectivité de ces miroirs n'est pas suffisante pour obtenir l'effet laser en continu.
   Plus récemment, il a été proposé d'utiliser un, voire deux réflecteurs de Bragg en AlAs/GaAs liés au milieu actif par collage épitaxial. On pourra à cet égard avantageusement se référer aux publications :
[3] J. J. Dudley et al., Appl. Phys. Lett., 64, 1463 (1994) ;
[4] D. I. Babic et al., Appl. Phys. Lett., 66, 1030 (1995).

Cette approche a permis d'obtenir l'effet laser à 1,55 µm en régime pulsé avec des courants de seuils intéressants, mais encore trop élevés pour obtenir le fonctionnement en régime continu.

On considère également généralement que cette technique n'est pas susceptible de déboucher sur des composants satisfaisants. Il est en effet communément admis par l'Homme du Métier que la réalisation de jonctions GaAs/InP par collage épitaxial s'accompagne d'une barrière de potentiel importante entre les deux matériaux, qui doit s'opposer au passage du courant et entraîner un échauffement de la structure, réduisant ainsi les chances d'obtenir le fonctionnement laser recherché.

Le but principal de l'invention est donc de proposer un composant laser à cavité verticale émettant par la surface pouvant fonctionner en continu à température ambiante à des longueurs d'onde comprises entre 1,3 et 1,5 µm.

On connaît déjà par les publications :
[5] D. L. Huffaker et al., Appl. Phys. Lett., 65, 97 (1994) ;
[6] K. D. Choquette et al. Electron. Lett., 30, 2043 (1994),
   des lasers à cavité verticale émettant par la surface à des longueurs d'onde de 0,98 µm, qui présentent un confinement latéral réalisé par oxidation sélective de la partie externe d'une couche AlAs gravée en plots (mesas).

A ce jour, cette technique n'a pas jamais été utilisée pour réaliser des lasers fonctionnant entre 1,3 et 1,5 µm étant donnée notamment qu'une couche d'AIAs de bonne qualité ne peut pas être facilement fabriqué pardessus la couche active des lasers de cette gamme en raison de la différence de paramètre de maille cristalline qui crée des réseaux de dislocations provoquant des pertes et un échauffement de la structure qui s'oppose à l'obtention de l'effet laser.

L'invention propose quant à elle un composant d'émission laser à cavité verticale émettant par la surface à une longueur d'onde comprise entre 1,3 et 1,55 µm, comportant un empilement présentant deux miroirs qui réfléchissent à la longueur d'onde d'émission et une ou plusieurs couches qui sont interposées entre ces deux miroirs et qui constituent un milieu amplificateur du rayonnement émis, caractérisé en ce qu'au moins un de ces miroirs présente au voisinage du milieu amplificateur une couche d'AlₓGa₁₋ₓAs, avec x compris entre 0,8 et 1, oxydée sélectivement autour d'une zone centrale active du milieu amplificateur permettant un fonctionnement dudit composant d'émission laser en continu à température ambiante.

Un tel composant présente un confinement latéral du courant électrique, dû au caractère isolant de la couche d'oxyde, combiné à un confinement latéral du mode optique de la cavité verticale, dû à son indice de réfraction, celui-ci étant nettement inférieur à celui de la zone centrale non oxydée.

De ce fait, en fonctionnement, la zone active subit un faible échauffement, ce qui permet un fonctionnement en régime continu à température ambiante.

L'invention propose également un procédé pour la réalisation d'un tel composant, caractérisé par les différentes étapes suivantes :
- épitaxies d'une part sur un substrat d'InP d'un empilement comportant les couches successives suivantes:
   . une couche d'InP de type n,
   . une ou plusieurs couches qui constituent le milieu amplificateur du rayonnement émis,
   . une couche d'InP de type p,
   . une couche terminale d'InGaAsp,
   et d'autre part sur un substrat de GaAs d'un empilement comportant au moins une couche d'AlₓGa₁₋ₓAs, avec x compris entre 0,8 et 1 et une couche terminale de GaAs,
- assemblage des deux échantillons ainsi obtenus par un traitement thermique réalisant le collage épitaxial de la couche de GaAs du deuxième échantillon sur une couche d'InP du premier,
- gravure sélective en plots de façon que la couche à la surface de l'échantillon entre les plots soit la couche d'AlₓGa₁₋ₓAs,
- oxydation par hydrolyse de la couche d'AlₓGa₁₋ₓAs pendant une durée telle qu'à l'issue de cette oxydation ladite couche est oxydée sélectivement autour d'une zone centrale active du milieu amplificateur,
- métallisation de la face supérieure des plots.

D'autres caractéristiques et avantages de l'invention ressortiront encore de la description qui suit.

Cette description est purement illustrative et non limitative. Elle doit être lue en regard des dessins annexés sur lesquels :
- la figure 1 est une représentation schématique en coupe d'un composant conforme à un premier mode de réalisation possible de l'invention ;
- la figure 2 est une représentation schématique en coupe d'un composant conforme à un autre mode de réalisation possible de l'invention.

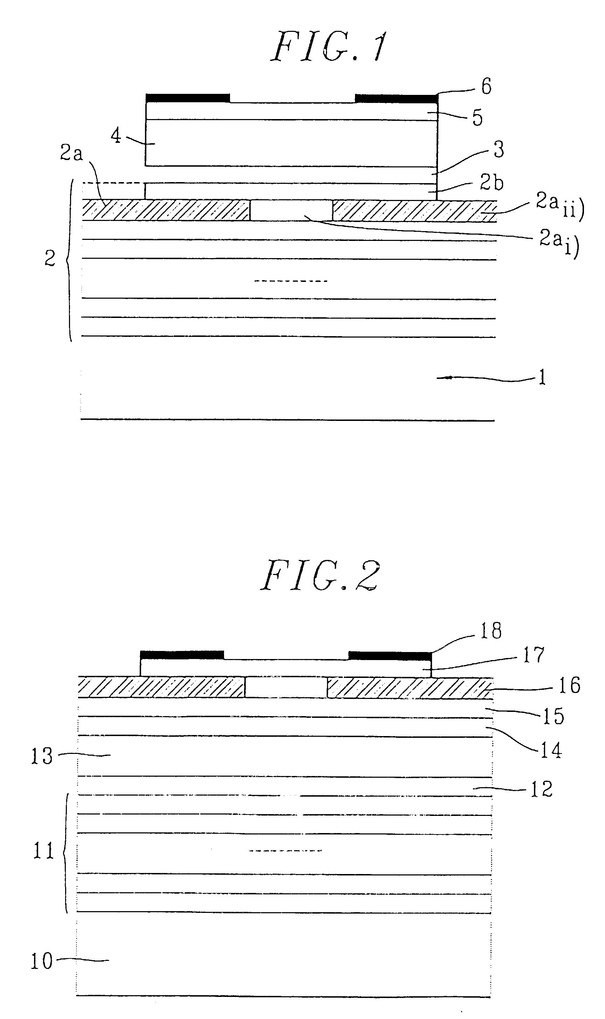

Le composant illustré sur la figure 1 est constitué par l'empilement sur un substrat 1 en GaAs dopé n des différentes couches successives suivantes:
- une pluralité de couches AlAs/GaAs définissant un miroir de Bragg 2,
- une couche 3 d'InP dopé n,
- une ou plusieurs couches qui constituent le milieu 4 amplificateur du rayonnement émis,
- une couche 5 d'InP dopé p,
- un dépôt métallique 6.

Les couches 3 à 6 définissent, avec la couche 2b de GaAs du miroir 2 qui est directement juxtaposée à la couche 3, un plot cylindrique ("mesa" selon la terminologie couramment employée par l'Homme du Métier) porté par le substrat 1 et le reste du miroir 2.

Le milieu amplificateur 4 est non intentionnellement dopé. Il peut être par exemple constitué par une couche d'InGaAsP ou par une structure à puits quantiques (InGaAsP)₁/(InGaAsP)₂. Les autres matériaux actifs habituellement utilisés comme matériaux lasers dans la gamme de longueurs d'onde 1,3 - 1,55 µm peuvent bien entendu également être utilisés.

Les couches d'AlAs et GaAs du miroir 2 sont des couches quart d'onde d'épaisseurs individuelles λ/4n, où λ est la longueur d'onde d'émission laser et n l'indice de réfraction à cette longueur d'onde.

Ces couches sont de type n, avec un dopage variable de manière à minimiser les résistances électriques parasites, telles que celles qui se manifestent aux interfaces entre les matériaux de haut et bas indices, et à obtenir simultanément une faible perte optique par absorption sur les porteurs libres dus au dopage.

Par exemple le dopage est choisi plus important au voisinage de l'interface GaAs/AlAs pour faciliter le passage du courant à travers l'interface.

En variante également, il est possible d'adopter une transition graduelle entre les couches de GaAs et d'AIAs en faisant varier progressivement la concentration d'aluminium.

Le nombre de paires de couches AlAs/GaAs doit être suffisant pour atteindre une réflectivité supérieure à 99 % (typiquement 25 à 30 paires sont nécessaires).

Conformément à l'invention, l'une des couches d'AlAs du miroir 2 au voisinage du milieu amplificateur 4 est oxydée sélectivement (couche 2a voisine de la couche 2b de GaAs précitée) : sa partie centrale 2aᵢ₎ au droit de la zone active du milieu amplificateur 4 est non oxydée et est entourée par un anneau 2aᵢᵢ₎ oxydé.

Cette structure oxydée sélectivement permet un fort confinement latéral du courant d'injection, ainsi qu'un fort confinement optique du faisceau émis.

La couche métallisée 6 sert à la fois de contact électrique et de réflecteur.

Elle peut couvrir entièrement le mesa, auquel cas la sortie du laser se fait à travers le substrat 1.

Elle peut également présenter, ainsi qu'illustré sur la figure 1, une géométrie annulaire, permettant à la lumière de sortir par le haut. Dans ce dernier cas le miroir supérieur 6 peut éventuellement être complété par un dépôt diélectrique multicouche classique qui améliore sa réflectivité.

La réalisation du composant de la figure 1 va maintenant être décrite.

Dans un premier temps, on réalise deux épitaxies, l'une sur un substrat d'InP, l'autre sur un substrat de GaAs.

Sur le substrat d'InP, on dépose successivement :
- une couche d'arrêt d'InGaAsP (non représentée),
- la couche 5 d'InP,
- le milieu amplificateur 4,
- la couche 3 d'InP,
- une couche terminale d'InGaAsP.

Sur le substrat 1 de GaAs de type n, on réalise par épitaxie l'empilement des couches AlAs/GaAs du miroir 2.

Après la réalisation des épitaxies, les deux échantillons obtenus sont assemblées par collage épitaxial de la façon suivante.

On enlève d'abord la couche terminale d'InGaAsP par attaque chimique sélective, par exemple par une solution à base d'acide sulfurique et d'eau oxygénée.

Puis, les surfaces des deux échantillons sont désoxydées, rincées, séchées, et placées dans un porte-échantillon en graphite qui les maintient l'un contre l'autre avec une pression uniforme.

L'ensemble est placé dans un four, qui est d'abord purgé à l'azote, puis maintenu dans une atmosphère d'hydrogène et soumis à une température de 630°C pendant 30 minutes.

Après retour à température ambiante, le porte-échantillon est retiré du four, et le collage épitaxial est terminé.

Après cette opération, on retire par deux attaques chimiques sélectives d'une part le substrat d'InP et d'autre part la couche d'arrêt d'InGaAsP.

Ensuite, l'échantillon est préparé en vue de la gravure des mesas par des techniques classiquement connues de l'Homme du Métier.

Par exemple, on dépose sur la couche 5 une couche diélectrique, puis d'une résine photosensible.

La résine est insolée à travers un masque définissant la géométrie des mesas (par exemple des disques de 50 µm de diamètre), chacun des mesas correspondant à un laser individuel.

Après révélation de la résine, une première gravure ionique réactive transfère le motif de résine sur la couche diélectrique, qui sert alors de masque pour la gravure des couches épitaxiées sur InP.

Cette deuxième gravure est effectuée dans des conditions permettant de s'arrêter sur la première couche de GaAs dopé n (couche 2b). Une dernière gravure sélective est effectuée pour retirer cette couche de GaAs, par exemple en trempant l'échantillon dans une solution d'acide succinique de pH 4,3 maintenu à une température de 50°C. Le matériau restant à la surface de l'échantillon entre les mesas est celui de la couche 2a en AlAs.

L'échantillon est ensuite soumis à une étape d'oxydation par hydrolyse, du type de celle décrite dans les références [5] et [6] précitées.

La couche 2a d'AlAs en surface est oxydée en plaçant l'échantillon pendant environ 3 minutes dans un four maintenu à 475°C. L'atmosphère du four est constituée d'un flux d'azote ayant barboté dans de l'eau désionisée chauffée à 95°C. L'oxydation 2aᵢᵢ) de la couche d'AlAs progresse latéralement de façon annulaire par diffusion sous les mesas.

La couche oxydée est en quelque sorte "enterrée" sous le mesa. L'anneau oxydé 2aᵢᵢ₎ ainsi constitué définit le passage du courant d'injection du laser à travers la partie centrale 2aᵢ₎ en AlAs de type n non oxydée. La taille de la partie centrale 2aᵢ₎ est ajustée en faisant varier le temps de passage dans la four. On notera par ailleurs que l'anneau oxydé 2aᵢ₎ maintient également une bonne isolation électrique entre les lasers individuels.

La couche 6 de contact électrique est ensuite déposée par métallisation au sommet du mesa, sur la couche 5 d'InP de type p.

Dans l'exemple correspondant au mode de réalisation illustré sur la figure 1, une ouverture d'un diamètre de 15 µm est aménagée dans la couche métallique au centre de chaque mesa de façon à permettre la sortie du rayonnement laser.

La cavité verticale est finalement complétée par le dépôt d'un empilement multicouche constituant le miroir supérieur, par exemple un empilement d'alternances SiO₂/TiO₂ déposées à froid au moyen d'une évaporation assistée par bombardement ionique.

Un autre mode de réalisation possible pour l'invention a été illustré sur la figure 2.

Ce composant est constitué par l'empilement sur un substrat 10 d'InP dopé n des différentes couches successives suivantes:
- une pluralité de couches de type n épitaxiées sur le substrat 10 et définissant un miroir de Bragg 11,
- une couche 12 d'InP dopé n,
- une ou plusieurs couches définissant le milieu amplificateur 13 du composant,
- une couche 14 d'Inp dopé p,
- une couche 15 de GaAs dopé p,
- une couche 16 d'AlAs oxydé sélectivement,
- une couche 17 de GaAs dopé p,
- ainsi qu'une couche supérieure 18 de métallisation éventuellement complétée par un dépôt diélectrique multicouche.

Pour la réalisation de ce composant, on réalise dans un premier temps deux épitaxies, l'une sur le substrat 10, l'autre sur un substrat de GaAs.

Sur le substrat 10 d'InP de type n, on fait croître successivement les différentes couches définissant le réflecteur de Bragg 11, la couche 12 d'InP de type n, le milieu amplificateur 13, la couche 14 d'InP de type p, ainsi qu'une couche terminale d'InGaAsP (non représentée).

Sur le substrat de GaAs, on fait croître successivement 4 couches de type p, à savoir une couche d'arrêt d'AlAs ou d'AlGaAs, la couche 17 de GaAs, la couche 16 d'AlAs qui sera oxydée sélectivement, ainsi qu'une couche terminale correspondant à la couche 15 de GaAs.

Le collage épitaxial des deux échantillons ainsi obtenus est réalisé comme décrit en référence à l'exemple de la figure 1.

On retire ensuite le substrat de GaAs et la couche d'arrêt par attaques chimiques sélectives.

On réalise les opérations nécessaires à la gravure des mesas sur la couche de GaAs. Cette gravure est beaucoup moins profonde que dans le premier exemple, et peut être réalisée simplement en trempant l'échantillon dans une solution d'acide succinique de pH 4,3 maintenu à une température de 50°C.

Le matériau restant à la surface de l'échantillon entre les mesas est alors de l'AlAs.

Ensuite l'opération d'oxydation par hydrolyse est réalisée comme décrit plus haut, puis on métallise en maintenant une ouverture centrale, et on réalise le dépôt du miroir diélectrique supérieur.

## Revendications

1. Composant d'émission laser à cavité verticale émettant par la surface à une longueur d'onde comprise entre 1,3 et 1,55 µm, comportant un empilement présentant deux miroirs (2, 6 ; 11, 18) qui réfléchissent à la longueur d'onde d'émission et une ou plusieurs couches (4, 13) qui sont interposée(s) entre ces deux miroirs (2, 6 ; 11, 18) et qui constituent un milieu amplificateur du rayonnement émis, caractérisé en ce qu'au moins un (2 ; 16, 17, 18) de ces miroirs présente au voisinage du milieu amplificateur (4, 13) une couche (2a, 16) d'AlₓGa₁₋ₓAs, avec x compris entre 0,8 et 1, oxydée sélectivement (2aᵢ₎ et 2aᵢᵢ₎) autour d'une zone centrale active du milieu amplificateur (4, 13), permettant un fonctionnement dudit composant d'émission laser en continu à température ambiante.

2. Composant selon la revendication 1, caractérisé en ce que la couche (2a, 16) oxydée sélectivement est une couche d'AlAs.

3. Composant selon la revendication 2, caractérisé en ce qu'il comprend l'empilement sur un substrat (1) en GaAs dopé n des différentes couches successives suivantes:
- une pluralité de couches AlAs/GaAs définissant un miroir de Bragg (2),
- une couche (3) d'InP dopé n,
- une ou plusieurs couches qui constituent le milieu amplificateur (4) du rayonnement émis,
- une couche (5) d'InP dopé p,
- un dépôt métallique (6),
la couche oxydée étant la couche (2a) d'AlAs du miroir de Bragg (2) la plus proche du milieu amplificateur (4), les couches (2b, 3 à 5) entre cette couche oxydée (2a) et le dépôt métallique (6) étant gravées en plots.

4. Composant selon la revendication 2, caractérisé en ce qu'il comprend l'empilement sur un substrat (10) d'InP dopé n des différentes couches successives suivantes:
- une pluralité de couches de type n définissant un miroir de Bragg (11),
- une couche (12) d'InP dopé n,
- une ou plusieurs couches qui constituent le milieu amplificateur (13) du rayonnement émis,
- une couche (14) d'Inp dopé p,
- une couche (15) de GaAs dopé p,
- une couche (16) d'AlAs oxydée sélectivement,
- une couche (17) de GaAs dopé p gravée en plots,
- un dépôt métallique (18).

5. Composant selon l'une des revendications 3 et 4, caractérisé en ce que le dépôt métallique présente un trou pour le passage de la lumière émise et est complété par un dépôt diélectrique multicouche.

6. Procédé pour la réalisation d'un composant selon l'une des revendications précédentes, caractérisé par les différentes étapes suivantes :
- épitaxies d'une part sur un substrat d'InP d'un empilement comportant les couches successives suivantes :
. une couche (3, 12) d'InP dopé n,
. une ou plusieurs couches qui constituent le milieu amplificateur (4, 13) du rayonnement émis,
. une couche (5, 14) d'InP dopé p,
. une couche terminale d'InGaAsp,
et d'autre part sur un substrat de GaAs d'un empilement comportant au moins une couche (2a, 16) d'AlₓGa₁₋ₓAs, avec x compris entre 0,8 et 1 et une couche terminale de GaAs,
- assemblage des deux échantillons ainsi obtenus par un traitement thermique réalisant le collage épitaxial de la couche de GaAs du deuxième échantillon sur une couche d'InP du premier,
- gravure sélective en plots de façon que la couche à la surface de l'échantillon entre les plots soit la couche (2a, 16) d'AlₓGa₁₋ₓAs,
- oxydation par hydrolyse de la couche (2a, 16) d'AlₓGa₁₋ₓAs pendant une durée telle qu'à l'issue de cette oxydation ladite couche est oxydée sélectivement autour d'une zone centrale active du milieu amplificateur (4, 13),
- métallisation de la face supérieure des plots.

7. Procédé selon la revendication 6 pour la réalisation du composant selon la revendication 3, caractérisé en ce qu'on dépose successivement d'une part par épitaxie sur le substrat d'InP :
- une couche d'arrêt d'InGaAsP,
- la couche (5) d'InP dopé p,
- la ou les couches qui constituent le milieu amplificateur (4) du rayonnement émis,
- la couche (3) d'InP dopé n,
- une couche terminale d'InGaAsP.
et d'autre part par épitaxie sur le substrat de GaAs de type n l'empilement des couches AlAs/GaAs du miroir de Bragg (2),
en ce qu'on enlève la couche terminale d'InGaAsP par attaque chimique sélective avant le traitement thermique de collage épitaxial,
en ce qu'après le traitement thermique de collage épitaxial, on retire par deux attaques chimiques sélectives d'une part le substrat d'InP et d'autre part la couche d'arrêt d'InGaAsP,
en ce qu'on réalise la gravure des différentes couches (2b, 3 à 5) comprises entre la couche (5) d'InP dopé p et la première couche (2b) de GaAs du miroir de Bragg, la couche (2a) à la surface de l'échantillon entre les plots étant la première couche d'AlAs du miroir de Bragg (2),
ladite couche (2a) d'AlAs étant ensuite oxydée sélectivement.

8. Procédé selon la revendication 6 pour la réalisation du composant selon la revendication 4, caractérisé en ce qu'on dépose successivement d'une part par épitaxie sur le substrat d'InP
- les différentes couches définissant le réflecteur de Bragg (11),
- la couche (12) d'InP de type n,
- la ou les couches qui constituent le milieu amplificateur (13) du rayonnement émis,
- la couche (14) d'InP de type p,
- ainsi qu'une couche terminale d'InGaAsP,
et d'autre part sur le substrat de GaAs, une couche d'arrêt d'AlAs ou d'AlGaAs, une couche (17) de GaAs, la couche (16) d'AlAs qui sera oxydée sélectivement, ainsi qu'une couche (15) terminale de GaAs,
en ce qu'on enlève la couche terminale d'InGaAsP par attaque chimique sélective avant le traitement thermique de collage épitaxial,
en ce qu'après le traitement thermique de collage épitaxial, on retire le substrat de GaAs et la couche d'arrêt par attaques chimiques sélectives,
en ce qu'on grave la couche (17) de GaAs de surface, la couche restant à la surface de l'échantillon entre les plots étant la couche (16) d'AlAs qui est ensuite oxydée sélectivement.

## Patentansprüche

1. Mit einer Wellenlänge zwischen 1,3 und 1,55 µm oberflächenemittierendes Laserbauelement mit vertikalem Resonator, welches einen Schichtaufbau umfaßt, der zwei Spiegel (2, 6; 11, 18), die auf der Emissionswellenlänge reflektieren, und mehrere Schichten (4, 13) aufweist, die zwischen den beiden Spiegeln (2, 6; 11, 18) angeordnet sind und ein Verstärkungsmedium für die emittierte Strahlung bilden, dadurch gekennzeichnet, daß wenigstens einer (2; 16, 17, 18) dieser Spiegel in der Nähe des Verstärkungsmediums (4, 13) eine Schicht (2a, 16) aus AlₓGa₁₋ₓAs aufweist, wobei x zwischen 0,8 und 1 liegt, die selektiv (2aᵢ) und (2aᵢᵢ) um den zentralen aktiven Bereich des Verstärkungsmediums (4, 13) oxidiert ist, was eine Funktion des besagten Laser-bauelementes immer auf Raumtemperatur erlaubt.

2. Bauelement nach Anspruch 1, dadurch gekennzeichnet, daß die selektiv oxidierte Schicht (2a, 16) eine AlAs Schicht ist.

3. Bauelement nach Anspruch 2, dadurch gekennzeichnet, daß es auf einem N dotierten Substrat (1) aus GaAs einen Schichtaufbau aus den folgenden verschiedenen aufeinanderfolgenden Schichten umfaßt:
- mehrere Schichten aus AlAs/GaAs, die einen Bragg-Spiegel (2) bilden,
- eine N dotierte Schicht (3) aus InP,
- eine Schicht oder mehrere Schichten, die das Verstärkungsmedium (4) für die emittierte Strahlung bildet oder bilden,
- eine P dotierte Schicht (5) aus InP,
- ein Metallüberzug (6),
wobei die oxidierte Schicht die Schicht (2a) aus AlAs des Bragg-Spiegels (2) ist, die dem Verstärkungsmedium (4) am nächsten liegt, und die Schichten (2a, 3 bis 5) zwischen der oxidierten Schicht (2a) und dem Metallüberzug (6) mesa-geätzt sind.

4. Bauelement nach Anspruch 2, dadurch gekennzeichnet, daß es auf einem N dotierten Substrat (10) aus InP die folgenden verschiedenen aufeinanderfolgenden Schichten umfaßt:
- mehrere Schichten vom N Typ, die einen Bragg-Spiegel (11) bilden,
- eine N dotierte Schicht (12) aus InP,
- eine Schicht oder mehrere Schichten, die das Verstärkungsmedium (13) für die emittierte Strahlung bildet oder bilden,
- eine P dotierte Schicht (14) aus InP,
- eine P dotierte Schicht (15) GaAs,
- eine selektiv oxidierte Schicht (16) aus AlAs,
- eine mesa-geätzte P dotierte Schicht (17) aus GaAs,
- ein Metallüberzug (18).

5. Bauelement nach einem der Ansprüche 3 und 4, dadurch gekennzeichnet, daß der Metallüberzug ein Loch zum Durchgang des emittierten Lichtes aufweist und durch einen mehrschichtigen dielektrischen Überzug vervollständigt ist.

6. Verfahren zum Herstellen eines Bauelements nach einem der vorhergehenden Ansprüche, gekennzeichnet durch die folgenden verschiedenen Schritte:
- epitaxiales Aufwachsen lassen einerseits auf einem Substrat aus InP einen Schichtaufbau, der nacheinander die folgenden Schichten umfaßt:
eine N dotierte Schicht (3, 12) aus InP,
eine Schicht oder mehrere Schichten, die das Verstärkungsmedium (4, 13) für die emittierte Strahlung bildet oder bilden, eine P dotierte Schicht (5, 14) aus InP,
eine Abschlußschicht aus InGaAsP,
und andererseits auf eine Substrat aus GaAs einen Schichtaufbau, der wenigstens eine Schicht (2a, 16) aus AlₓGa₁₋ₓAs, wobei x zwischen 0,8 und 1 liegt, und eine Abschlußschicht aus GaAs umfaßt,
- Zusammensetzen der beiden in dieser Weise erhaltenen Musterstücke über eine Wärmebehandlung, die zu einem epitaxialen Zusammenfügen der Schicht aus GaAs des zweiten Musterstücks an einer Schicht aus InP des ersten führt,
- selektives Mesaätzen derart, daß die Schicht an der Oberfläche des Musterstücks zwischen den Mesabereichen zu der Schicht (2a, 16) aus AlₓGa₁₋ₓAs wird,
hydrolytisches Oxidieren der Schicht (2a, 16) aus AlₓGa₁₋ₓAs während einer derartigen Zeitdauer, daß am Ende dieser Oxidation die besagte Schicht selektiv um einen mittleren aktiven Bereich des Verstärkungsmediums (4, 13) oxidiert ist,
Metallisieren der oberen Außenfläche der Mesabereiche.

7. Verfahren nach Anspruch 6 zur Herstellung eines Bauelementes nach Anspruch 3, dadurch gekennzeichnet, daß man nacheinander aufbringt einerseits durch epitaxiales Wachstum auf dem Substrat aus InP:
- eine Endachicht aus InGaAsP,
- die P dotierte Schicht (5) aus InP,
- die Schicht oder die Schichten, die das Verstärkungsrmedium für die emittierte Strahlung bildet oder bilden,
- die N dotierte Schicht (3) aus InP,
- eine Abschlußschicht aus InGaAsP,
und andererseits durch epitaxiales Wachstum auf dem Substrat aus GaAs vom N Typ, den Schichtaufbau der Schichten aus AlAs/GaAs des Bragg-Spiegels (2),
daß man die Abschlußschicht aus InGaAsP durch selektives chemisches Ätzen vor der Wärmebehandlung zum epitaxialen Zusammenfügen entfernt,
daß man nach der Wärmebehandlung zum epitaxialen Zusammenfügen durch zweifaches selektives chemisches Ätzen einerseits das Substrat aus InP und andererseits die Endschicht aus InGaAsP entfernt,
daß man die verschiedenen Schichten (2b, 3 bis 5) zwischen der P dotierten Schicht (5) aus InP und der ersten Schicht (2b) aus GaAs des Bragg-Spiegels ätzt, so daß die Schicht (2a) auf der Oberfläche des Musterstücks zwischen den Mesabereichen zur ersten Schicht aus AlAs des Bragg-Spiegels (2) wird, welche Schicht (2a) aus AlAs dann selektiv oxidiert wird.

8. Verfahren nach Anspruch 6 zur Herstellung eines Bauelementes nach Anspruch 4, dadurch gekennzeichnet, daß man nacheinander einerseits durch epitaxiales Wachstum auf dem Substrat aus InP
- die verschiedene Schichten, die den Bragg-Reflektor (11) bilden,
- die N dotierte Schicht (12) aus InP,
- die Schicht oder die Schichten, die das Verstärkungsmedium (13) für die emittierte Strahlung bildet oder bilden,
- die P dotierte Schicht (14) aus InP,
- und dann eine Abschlußschicht aus InGaAsP aufbringt
- und andererseits auf dem Substrat aus GaAs eine Endschicht aus AlAs oder AlGaAs, eine Schicht (17) aus GaAs, die Schicht (16) aus AlAs, die selektiv oxidiert werden soll, und dann eine Abschlußschicht (15) aus GaAs aufbringt,
daß man die Abschlußschicht aus InGaAsP durch selektives chemischen Ätzen vor der Wärmebehandlung zum epitaxialen Zusammenfügen entfernt,
- daß man nach der Wärmebehandlung zum epitaxialen Zusammenfügen das Substrat aus GaAs und die Endschicht durch selektive chemische Ätzvorgänge entfernt,
daß man die Schicht (17) aus GaAs an der Oberfläche ätzt, so daß die an der Oberfläche des Musterstücks zwischen den Mesabereichen bleibende Schicht zu der Schicht (16) aus AlAs wird, die dann selektiv oxidiert wird.

## Claims

1. A vertical cavity laser emission component emitting via the surface at a wavelength lying in the range 1.3 pm to 1.55 pm, the component comprising a stack having two mirrors (2, 6; 11, 18) which reflect at the emission wavelength, plus one or more layers (4, 13) which are interposed between the two mirrors (2, 6; 11, 18) and which constitute an amplifying medium for the emitted radiation, the component being characterized in that, in the vicinity of the amplifying medium (4, 13), at least one (2; 16, 17, 18) of the mirrors presents a layer (2a, 16) of AlₓGa₁₋ₓAs where x lies in the range 0.8 to 1, which layer is selectively oxidized (2aᵢ₎ and 2aᵢᵢ₎) around an active central zone of the amplifying medium (4, 13), enabling said laser emission component to operate continuously at ambiant temperature.

2. A component according to claim 1, characterized in that the selectively oxidized layer (2a, 16) is a layer of AlAs.

3. A component according to claim 2, characterized in that it comprises, on a substrate (1) of N-doped GaAs, a stack of the following layers in succession:
· a plurality of AlAs/GaAs layers defining a Bragg mirror (2);
· an N-doped InP layer (3);
· one or more layers constituting the medium (4) for amplifying the emitted radiation;
· a P-doped InP layer (5); and
· a metal deposit (6);
the oxidized layer being the AlAs layer (2a) of the Bragg mirror (2) closest to the amplifying medium (4), the layers (2b, 3 to 5) between said oxidized layer (2a) and the metal deposit (6) being etched into mesas.

4. A component according to claim 2, characterized in that it comprises, on an N-doped InP substrate (10), a stack of the following layers in succession:
· a plurality of N type layers defining a Bragg mirror (11);
· an N-doped InP layer (12);
· one or more layers constituting the medium (13) for amplifying the emitted radiation;
· a P-doped InP layer (14);
· a P-doped GaAs layer (15);
· a selectively oxidized layer (16) of AlAs;
· a P-doped GaAs layer (17) etched into mesas; and
· a metal deposit (18).

5. A component according to claim 3 or 4, characterized in that the metal deposit has a hole for passing the emitted light and is finished off with a multilayer dielectric deposit.

6. A method of making a component according to any preceding claim, characterized by the following steps:
· firstly, on an InP substrate, epitaxially growing a stack comprising the following layers in succession:
- an N-doped InP layer (3, 12);
- one or more layers constituting the medium (4, 14) for amplifying the emitted radiation;
- a P-doped InP layer (5, 14); and
- an InGaAsP terminal layer;
· secondly, on a GaAs substrate, epitaxially growing a stack including at least one layer (2a, 16) of AlₓGa₁₋ₓAs with x lying in the range 0.8 to 1, plus a terminal layer of GaAs;
· assembling together the two samples obtained in this way by heat treatment achieving epitaxial adhesion of the GaAs layer of the second sample to an InP layer of the first sample;
· selectively etching mesas so that the layer at the surface of the sample between the mesas is the AlₓGa₁₋ₓAs layer (2a, 16);
· oxidizing the AlₓGa₁₋ₓAs layer (2a, 16) by hydrolysis for a length of time such that at the end of said oxidation said layer is selectively oxidized around an active central zone of the amplifying medium (4, 13); and
· metallizing the top faces of the mesas.

7. A method according to claim 6 for making the component of claim 3, the method being characterized in that,
on the InP substrate, the following are deposited epitaxially in succession:
· an InGaAsP stop layer;
· a P-doped InP layer (5);
· the layer(s) constituting the medium (4) for amplifying the emitted radiation;
· the N-doped InP layer (3); and
· an InGaAsP terminal layer;
on the N type GaAs substrate, the stack of AlAs/GaAs layers of the Bragg mirror (2) is deposited epitaxially;
the InGaAsP terminal layer is removed by selective chemical etching prior to the heat treatment for epitaxial adhesion;
after the heat treatment for epitaxial adhesion, both the InP substrate and the InGaAsP stop layer are removed in two selective chemical etching operations;
the various layers (2b, 3 to 5) between the P-doped InP layer (5) and the first GaAs layer (2b) of the Bragg mirror are etched, with the layer (2a) at the surface of the sample between the mesas being the first AlAs layer of the Bragg mirror (2); and then
said AlAs layer (2a) is selectively oxidized.

8. A method according to claim 6 for making the component of claim 4, characterized in that:
on the InP substrate, the following layers are deposited in succession:
· the various layers defining the Bragg reflector (11);
· the N type InP layer (12);
· the layer(s) constituting the medium (13) for amplifying the emitted radiation;
· the P type InP layer (14); and
· an InGaAsP terminal layer;
on the GaAs substrate, the following are epitaxially deposited: a stop layer of AlAs or of AlGaAs, a layer (17) of GaAs, the layer (16) of AlAs that is to be selectively oxidized, and a terminal layer (15) of GaAs;
the InGaAsP terminal layer is removed by selective chemical etching before the heat treatment for epitaxial adhesion;
after the heat treatment for epitaxial adhesion, the GaAs substrate and the stop layer are removed by selective chemical etching; and
the surface GaAs layer (17) is etched so that the layer remaining at the surface of the sample between the mesas is the AlAs layer (16) which is subsequently selectively oxidized.
